# EUROPEAN PATENT APPLICATION

(11) **EP 4 679 494 A2**
(43) Date of publication of application: **14.01.2026**
(21) Application number: 25176077.3
(22) Date of filing: 13.05.2025
(51) Int. Cl.: H01L 21/3063

(54) **METHOD AND SYSTEM FOR EFFICIENT PHOTOELECTROCHEMICAL ETCHING OF SILICON CARBIDE AND SILICON CARBIDE ON INSULATOR USING LED LAMP**

(30) Priority: 20.06.2024 US 202418748793
(71) Applicant: The Boeing Company, Arlington, VA 22202 (US)
(72) Inventor: LIPTON, Jason Samuel, 22202 Arlington (US); GRAETZ, Jason Allan, 22202 Arlington (US); SORENSEN, Adam Eric, 22202 Arlington (US); VAJO, John James, 22202 Arlington (US); WHITELEY, Samuel James, 22202 Arlington (US); CUI, Shanying, 22202 Arlington (US)
(74) Representative: Morrall, Jonathan Ian McLachlan

(57) **Abstract**

A method for etching a substrate using a light emitting diode (LED) lamp includes placing the substrate in an etching chamber equipped with the LED lamp configured to emit ultra-violet (UV) having a selected wavelength. The method includes submerging the substrate in an electrolyte solution within the etching chamber and applying a bias voltage between the substrate and the electrolyte solution. The method includes illuminating the substrate with the UV light to irradiate the substrate's surface. The method includes removing the substrate from the electrolyte solution once a desired etch depth is achieved.

## Description

### BACKGROUND INFORMATION

### 1. Field:

The present disclosure relates generally to semiconductors, and more specifically to a method and system for efficient photoelectrochemical etching of silicon carbide and silicon carbide on insulator using LED lamp.

### 2. Background:

Photonic circuits, also known as integrated optical circuits, manipulate photons to perform various functions similar to how electronic circuits manipulate electrons. Photonic circuits are used in applications such as telecommunications, sensing, signal processing, and quantum computing. Photonic circuits include components like waveguides, modulators, detectors, and light sources integrated on a chip.

Silicon Carbide on Insulator (SiCOI)technology is widely used in the fabrication of photonic circuits. SiCOI is a semiconductor technology that integrates a thin layer of silicon carbide (SiC) on an insulating substrate, typically silicon dioxide (SiO2). SiC has wide bandgap characteristics which allow operation at higher frequencies and powers, reducing signal loss and increasing efficiency. Also, SiC dissipates heat effectively which is crucial for high-power photonic applications. Furthermore, SiC is resistant to harsh environmental conditions, making it suitable for durable photonic devices. These properties make SiC ideal in photonic circuits.

An SiCOI structure includes multiple layers. A substrate layer (e.g., Si) provides a mechanical support base. An insulator layer (e.g., silicon dioxide (SiO2)) is formed on top of the substrate layer. The insulator layer electrically isolates a top layer (e.g., thin layer of SiC) from the substrate layer, minimizing parasitic capacitance and leakage current. Photonic devices are fabricated on the top layer.

A process known as photoelectrochemical (PEC) etching is used to etch SiC material to a desired etch depth (e.g., 1 micrometer, 5 micrometers, 7 micrometers). An SiC substrate is placed in an etching chamber equipped with an ultra-violet (UV) light source (e.g., mercury lamp). The SiC substrate is submerged in an electrolyte solution within the etching chamber, and a bias voltage is applied between the substrate and the electrolyte solution. The substrate is then illuminated with UV light emitted by the light source. As the UV light irradiates the substrate's surface, an oxidation reaction forms oxide (e.g., SiO2) on the surface. The oxide is subsequently dissolved by the electrolyte solution. The substrate is etched until a desired etch depth is achieved. The etch rate of the substrate and the etching surface roughness are controlled by varying the intensity of the UV light and by adjusting the bias voltage.

In photonic circuits, maintaining a uniform cross-sectional dimension of a wafer is crucial for consistent light propagation. Thickness variations in SiC can change the optical path lengths, causing phase errors and signal degradation. Non-uniform SiC layers can lead to refractive index variations, impacting the performance of devices like modulators, resonators, and filters. The variation in thickness is measured as the Total Thickness Variation (TTV) which is the difference between the maximum and minimum thicknesses observed in a material layer across a wafer. A low TTV indicates that the SiC layer is planar and uniform in thickness. A high TTV indicates there are significant thickness variations, which can lead to poor device performances and issues in subsequent processing steps.

Traditional mercury lamps have drawbacks because they produce non-uniform light intensity across the wafer surface. The emitted light can create hot spots (higher intensity areas) and dark spots (lower intensity areas), leading to uneven generation of electron-hole pairs on the SiC surface. This uneven light intensity causes non-uniform etching rates, where areas exposed to higher intensity light etch faster and remove more material, while areas with lower intensity light etch slower. This discrepancy directly contributes to increased Total Thickness Variation (TTV). Also, mercury lamps emit light having a wide range of wavelengths, not all of which are effective for the etching process. While UV light is essential for generating electron-hole pairs in SiC, mercury lamps also emit visible and infrared light, which do not aid in the etching process and can cause unwanted heating.

Also, traditional methods typically utilize hydrofluoric acid (HF) as the electrolyte solution. However, HF poses safety hazards due to its corrosive nature.

### SUMMARY

Illustrative embodiments provide a method for etching a substrate using a light emitting diode (LED) lamp. The method includes placing the substrate in an etching chamber equipped with the LED lamp configured to emit ultra-violet (UV) light having a selected wavelength. The method includes submerging the substrate in an electrolyte solution within the etching chamber and applying a bias voltage between the substrate and the electrolyte solution. The method includes illuminating the substrate with the UV light to irradiate the substrate's surface. The method includes removing the substrate from the electrolyte solution once a desired etch depth is achieved.

In an illustrative embodiment, the selected wavelength is less than 300nm, and in other embodiments, the selected wavelength is 275nm.

In an illustrative embodiment, the substrate comprises silicon carbide (SiC), and in other embodiments, the substrate comprises silicon carbide on insulator (SiCOI).

In an illustrative embodiment, the method includes adjusting the intensity of the UV light to control the etching rate and etching surface roughness. The method includes adjusting the bias voltage to control the etching rate. The method includes rinsing the etched substrate with deionized water to remove any residual electrolyte solution and drying the substrate.

In an illustrative embodiment, a method for etching a substrate using a light emitting diode (LED) lamp includes placing the substrate in an etching chamber equipped with the LED lamp configured to emit ultra-violet (UV) having a wavelength less than 300nm, wherein the substrate comprises silicon carbide (SiC) or silicon carbide on insulator (SiCOI). The method includes submerging the substrate in an electrolyte solution within the etching chamber, wherein the electrolyte solution is an aqueous solution of potassium hydroxide (KOH), sodium hydroxide (NaOH) or lithium hydroxide (LiOH). The method includes applying a bias voltage between the substrate and the electrolyte solution and illuminating the substrate's surface with the UV light to irradiate the surface. The method includes removing the substrate from the electrolyte solution once a desired etch depth is achieved.

In an illustrative embodiment, a system for etching a substrate includes an etching chamber configured to hold the substrate. The system includes an LED lamp positioned within the etching chamber and configured to emit UV light at a wavelength of less than 300nm. The system includes an electrolyte solution comprising an aqueous solution of potassium hydroxide (KOH) at a selected concentration. The system includes a voltage source configured to apply a bias voltage between the substrate and the electrolyte solution, wherein the substrate's surface is illuminated with the UV light to irradiate the surface.

### BRIEF DESCRIPTION OF THE DRAWINGS

The novel features believed characteristic of the illustrative embodiments are set forth in the appended claims. The illustrative embodiments, however, as well as a preferred mode of use, further objectives and features thereof, will best be understood by reference to the following detailed description of an illustrative embodiment of the present disclosure when read in conjunction with the accompanying drawings, wherein:
FIG. 1A illustrates a system in accordance with an illustrative embodiment;
FIG. 1B illustrates current vs. voltage graphs of etching of n-type and p-type layers;
FIG. 2A illustrates an example of PEC etching of an n-type substrate;
FIG. 2B shows current vs. voltage graphs using an LED lamp and a mercury lamp;
FIG. 2C illustrates etch rates at a constant bias voltage;
FIG. 3A illustrates etching of an example SiC substrate;
FIG. 3B illustrates current vs. voltage graphs of the SiC substrate's etching;
FIG. 3C illustrates a voltage vs. time graph with a constant bias voltage;
FIG. 4A illustrates etching of a trenched substrate submerged in a KOH solution;
FIG. 4B shows current vs. voltage graphs of etching of trenched substrate;
FIG. 4C illustrates current vs. time graphs of the etching of the trenched substrate; and
FIG. 5 is a flow diagram of a process for photoelectrochemical (PEC) etching in accordance with an illustrative embodiment.

### DETAILED DESCRIPTION

The illustrative embodiments address limitations of current photoelectrochemical (PEC) etching. The illustrative embodiments provide a method and system for efficient PEC etching of silicon carbide (SiC) and silicon carbide on insulator (SiCOL) using LED lamps. Also, the illustrative embodiments allow PEC etching without requiring hydrofluoric acid (HF) as the electrolyte, thus providing an environmentally safer PEC etching.

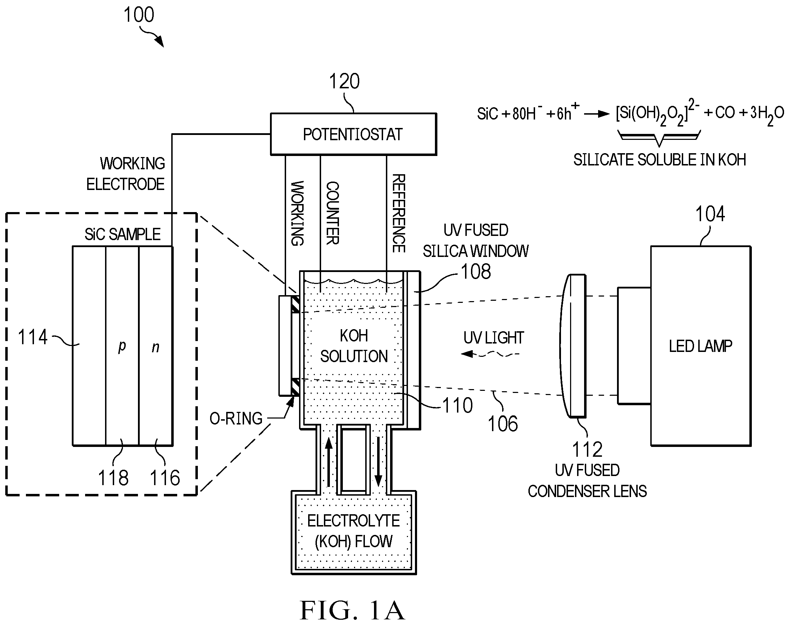

FIG. 1A illustrates System 100 in accordance with an illustrative embodiment. System 100 includes light emitting diode (LED) lamp 104 configured to emit ultra-violet (UV) light 106. In an illustrative embodiment, LED lamp 104 is configured to emit UV light 106 having a wavelength of 300nm or less. In another illustrative embodiment, LED lamp 104 is configured to emit UV light 106 having a wavelength of around 275 nm. LED lamp 104 is configured to emit light having a wavelength (e.g., 300 nm or less) which is effective for the PEC etching.

System 100 includes container 108 which holds electrolyte solution 110. In an illustrative embodiment, electrolyte solution 110 is an aqueous solution of potassium hydroxide (KOH). In another illustrative embodiment, electrolyte solution 110 is an aqueous solution of sodium hydroxide (NaOH), lithium hydroxide (LiOH) or a combination thereof. Electrolyte solution 110 is prepared at a desired concentration (e.g., .2 M). Container 110 may include channels and pumps to facilitate circulation of electrolyte solution 110.

Electrolyte solution 110 acts as an etchant to induce chemical reaction in the material to be etched. Electrolyte solution 110 is substantially transparent to UV light 106, allowing the UV light to pass through. Electrolyte solution 110 does not change the wavelength of the UV light passing through it, which is crucial for generating electron-hole pairs in the semiconductor material during PEC etching. Also, the transparency of electrolyte solution 110 ensures that the intensity of the UV light remains largely unaffected as it passes through. This transparency is important because consistent light intensity is necessary to maintain uniform etching rates across the semiconductor surface.

Condenser lens 112 is placed between LED lamp 104 and container 108 in the light path to focus UV light 106. For example, UV-fused silica condenser lens can be used to focus the light.

System 100 includes substrate 114 which, for example, can be SiC or SiCOI. In the illustrative embodiment, substrate 114 includes n-type layer 116 on top of p-type layer 118. N-type layer 116 is doped with donor impurities to give it n-type characteristics, while p-type layer 118 is doped with acceptor impurities to impart p-type properties.

System 100 includes voltage supply 120 configured to apply a bias voltage between substrate 114 and KOH solution 110. Voltage supply 120 can be a variable voltage supply configured to adjust the bias voltage between substrate 114 and KOH solution 110. By varying the bias voltage, the etch rate of substrate 114 can be controlled. In another example embodiment, the bias voltage is constant. The etch rate and etching surface roughness can also be controlled by varying the intensity of the UV light.

LED lamp 104 is a solid-state lighting device that emits light when an electric current passes through it. A driver circuit applies an appropriate voltage required by LED 104. LED lamp 104 comprises a semiconductor material that emits light when energized. The core of LED lamp 104 is typically made of materials like gallium arsenide (GaAs) or gallium nitride (GaN), which determines the wavelength of light emission. The core is encapsulated in a transparent plastic lens that helps to focus and direct the light.

The key advantages of LED lamp 104 include high energy efficiency, long lifespan and low heat generation. LED lamps 104 is configured to emit light having a wavelength (e.g., 300 nm or less) which is effective for the etching process. In contrast, traditional methods typically utilize mercury lamps which emit light having a wide range of wavelengths, not all of which are effective for the etching process.

Another advantage is that an LED array comprising multiple individual LEDs can be built. An LED array provides greater light output than a single LED. The LED array can be configured in series, parallel, or a combination of both, depending on the desired application and electrical requirements.

In operation, substrate 114 is submerged in electrolyte solution 110 and a bias voltage is applied between substrate 114 and KOH solution 110. In the absence of UV light, substrate surface remains inert in relation to electrolyte solution 108. However, when UV light 106 illuminates the substrate surface, an electric field is generated which drives the movement of ions between substrate 114 and electrolyte solution 110, facilitating the electrochemical reactions necessary for etching. The electric field aids in oxidizing the material on the substrate surface, making it more soluble in solution 110.

System 100 can be used to selectively etch either n-type layer 116 or p-type layer 118. In general, to etch an n-type layer, a higher bias voltage is applied, and to etch a p-type layer, a lower bias voltage is applied.

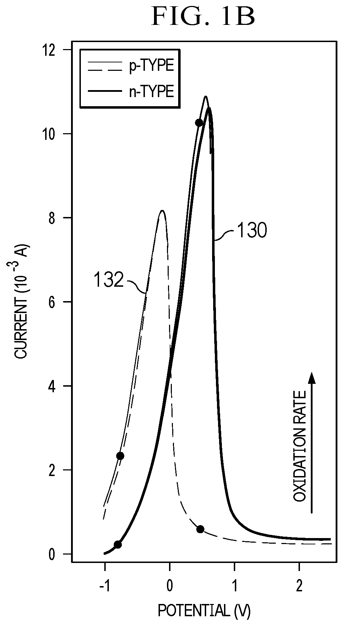

FIG. 1B illustrates current vs. voltage graphs 130 and 132 of respective n-type layer 116 and p-type layer 118. Graphs 130 and 132 indicate etch rates of the layers.

In a first phase, to selectively etch n-type layer 116, a bias voltage of around .85V is applied between substrate 114 and KOH solution 110. The etch rate (oxidation rate) is proportional to the current flow. In this illustrative embodiment, the resulting current is around 11mA which causes n-type layer 116 to be etched. When etching reaches p-type layer 118, the current substantially falls, indicating that p-type layer 118 is minimally etched.

In a second phase, to etch p-type layer 118, a bias voltage of around -0.5V is applied. The resulting current is around 8mA, which causes p-type layer 118 to be etched. When p-type layer 118 is removed, the current substantially falls, indicating that the etch rate has fallen.

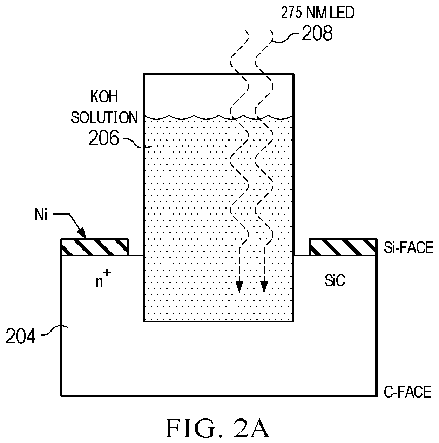

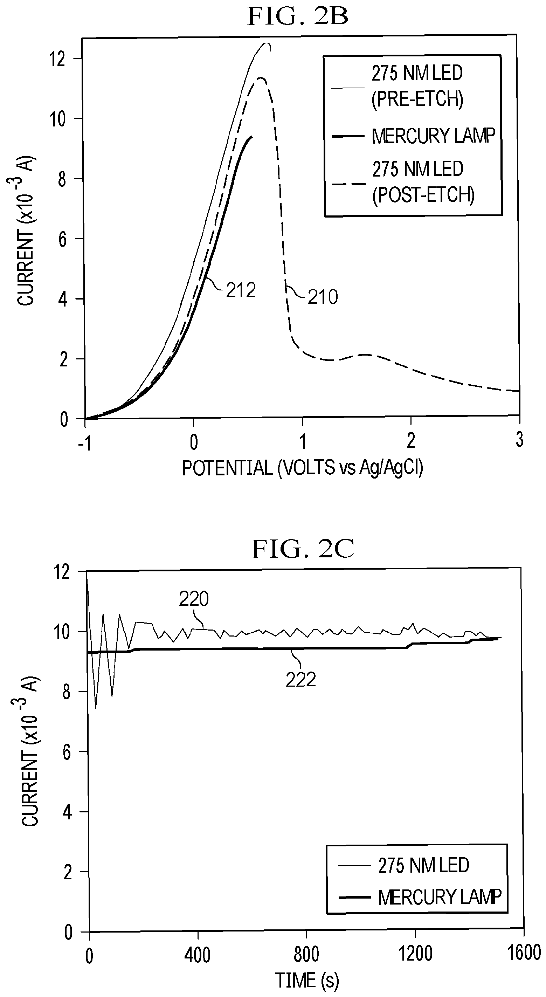

FIG. 2A illustrates an example of PEC etching of n-type substrate 204 submerged in KOH solution 206 and illuminated with 275 nm LED light 208. Substrate 204 can be formed using, for example, SiC. FIG. 2B shows a current vs. voltage graph 210 (275 nm LED lamp) and a current vs. voltage graph 212 (mercury lamp). Graphs 210 and 212 indicate etch rates of the substrate. As shown in FIG. 2B, the 275nm LED lamp has a very similar etching rate as the mercury lamp. FIG. 2C illustrates etch rate graph 220 (275nm LED) and etch rate graph 222 (mercury lamp) at a constant bias voltage. If the voltage is held constant (e.g., .8V), 275nm LED 220 and mercury lamp 222 produce a similar etch rate.

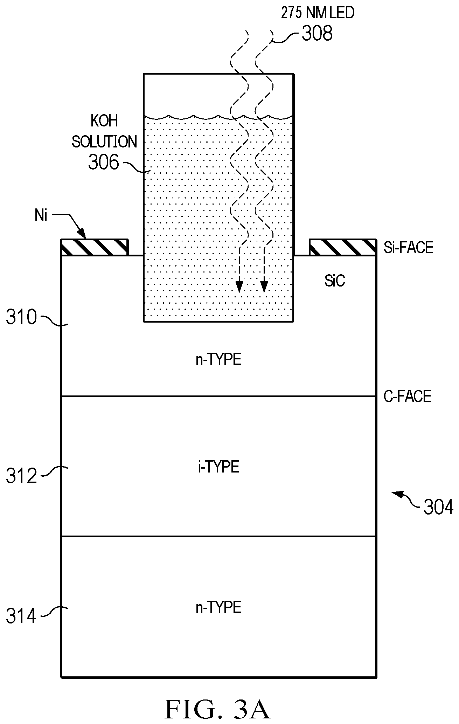

FIG. 3A illustrates PEC etching of SiC substrate 304 submerged in KOH solution 306 and illuminated with 275 nm LED 308. Substrate 304 includes n-type layer 310 (top layer), i-type layer 312 (middle layer) and n-type layer 314 (bottom layer).

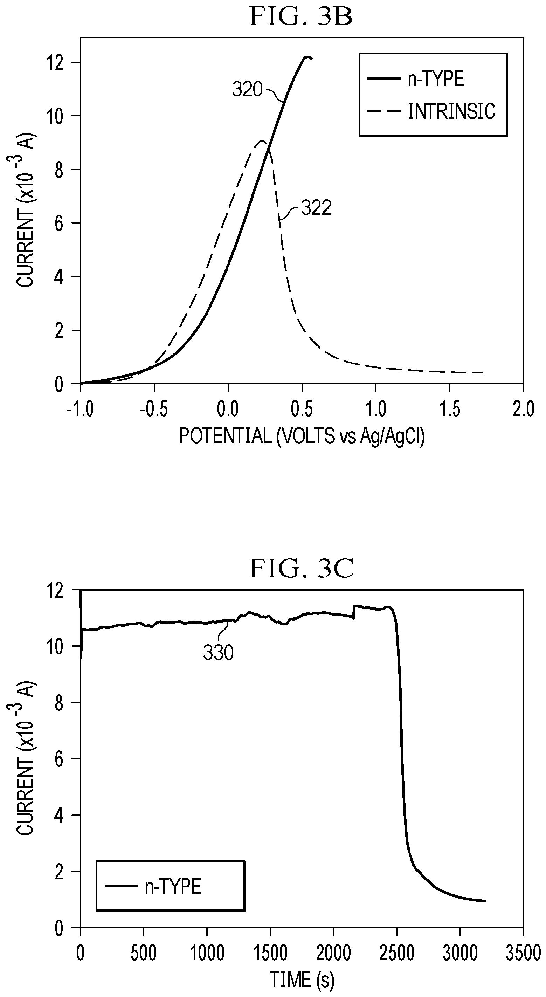

FIG. 3B illustrates current vs. voltage graphs 320. In a first phase, the bias voltage is held around .8V to selectively etch n-type layer 310. In this phase (graph 320), n-type layer 310 is etched while i-type layer 312 is minimally etched.

In a second phase, when etching reaches i-type layer 312, the bias voltage is held -.8V to selectively etch i-type layer 312. In this phase (graph 322), i-type layer 312 is etched while n-type layer 310 is minimally etched.

FIG. 3C illustrates graph 330 of voltage vs. time during etching with a constant bias voltage. In this example, the bias voltage is held at a constant level (e.g., .8V) to selectively etch n-type layer 310. As shown, n-type layer 310 is selectively etched until time T=2500 seconds when etching reaches i-type layer 312. At that time, current substantially falls, indicating a substantial fall in the etch rate. As a result, i-type layer 312 is minimally etched.

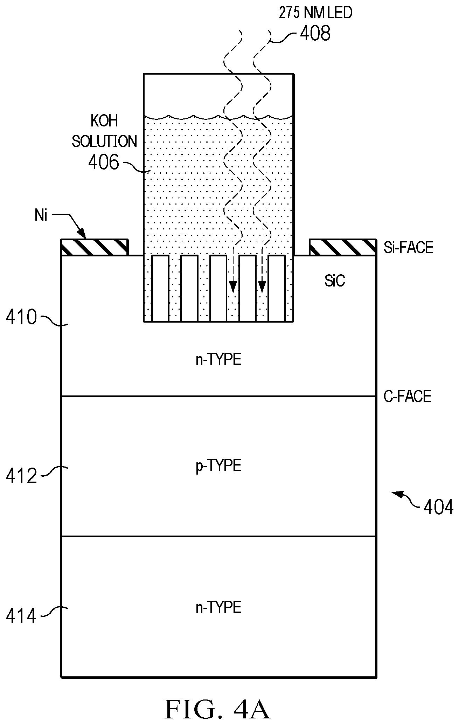

FIG. 4A illustrates etching of substrate 404 submerged in KOH solution 406 and illuminated with 275nm LED 408. In this example, substrate 404 includes n-type layer 410 (top layer), p-type layer 412 (middle layer), and n-type layer 414 (bottom layer). Top n-type layer 410 is trenched.

In a first phase, the bias voltage is held at around 0.55 to etch n-type layer 410 (top layer). During etching, the trench bottoms of n-type layer 410 are etched as well as the top surface of n-type layer 410. As the trench depth increases due to etching, the trench bottoms reach p-type layer 412. Since the bias voltage is set to selectively etch n-type layer 410, when the trench bottoms reach p-type layer 412, the top surface of n-type layer 410 continues to be etched but p-type layer 412 is minimally etched. By comparing the etch rate of top surface of n-type layer 410 with etch rate of p-type layer 412, the selectivity ratio can be determined.

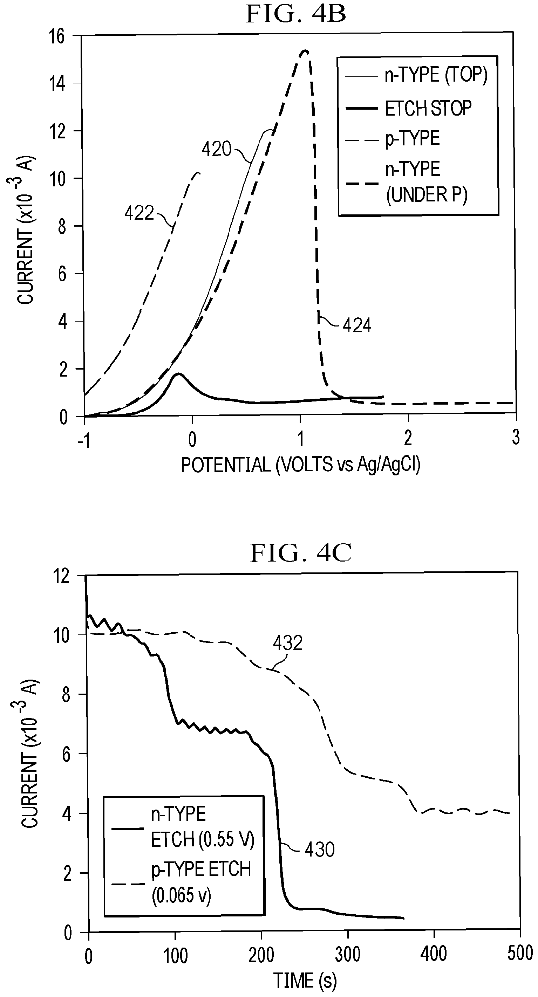

FIG. 4B shows current vs. voltage graphs 420, 422 and 424 associated with etching of n-type layer 410, p-type layer 412 and n-type layer 414, respectively. In this example, the selectivity ratio of etch of n-type layer 410 to p-type layer 412 is around 20:1.

In a second phase, the bias voltage is held to around .06V to selectively etch p-type layer 412. When etching finally reaches n-type layer 404, the etching rate falls. In this phase, the selectivity ratio is 2.5:1.

FIG. 4C illustrates current vs. time graphs 430 and 432 associated with the etching of n-type layer 410 and p-type layer 412. In a first phase, the bias voltage is set at 0.55V to selectively etch n-type layer 410, and in a second phase, the bias voltage is set at .065V to selectively etch p-type layer 412,

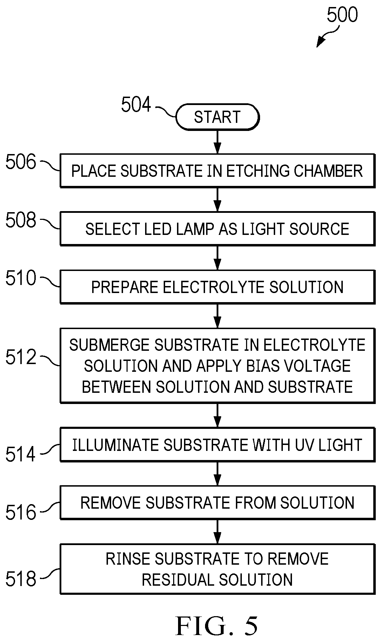

FIG. 5 is a flow diagram of process 500 for photoelectrochemical (PEC) etching in accordance with an illustrative embodiment. Process 500 starts in block 504, and in block 506 a substrate is placed in an etching chamber equipped with a UV light source. In an illustrative embodiment, the substrate is silicon carbide

(SiC) or silicon oxide on insulator (SiCOI). In block 508, a UV light source with a specific wavelength suitable for the photoelectrochemical process is selected. In an illustrative embodiment, the UV light source is an LED lamp configured to emit light having a wavelength of around 275nm.

In block 510, an electrolyte solution is prepared. In an illustrative embodiment, the electrolyte solution is an aqueous solution of potassium hydroxide (KOH) prepared at a desired concentration. Common concentrations range from 1 M to 5 M, depending on the required etching rate and the specific application. In block 512, the substrate is submerged in the electrolyte solution within the etching chamber and a bias voltage is applied between the substrate and the electrolyte solution.

In block 514, the substrate is illuminated with the UV light. The light irradiates the surface uniformly to ensure consistent etching across the substrate. As the UV light irradiates the substrate's surface, electron-hole pairs are generated. The holes (positive charges) facilitate the oxidation of the substrate, while the electrons (negative charges) participate in reduction reactions. The oxidation reaction forms oxide (e.g., SiO2) on the surface, which is subsequently dissolved by the KOH etchant. The intensity of the UV light and the concentration of the electrolyte solution are adjusted as needed to control the etching rate and achieve the desired etch depth and surface quality.

In block 516, once the desired etch depth is achieved, the UV light is turned off and the substrate is removed from the etchant solution. In block 518, the etched substrate is rinsed with deionized water to remove any residual electrolyte solution. The substrate is then dried using nitrogen gas or a suitable drying method.

As used herein, "a number of," when used with reference to items, means one or more items. For example, "a number of different types of networks" is one or more different types of networks.

Further, the phrase "at least one of," when used with a list of items, means different combinations of one or more of the listed items can be used, and only one of each item in the list may be needed. In other words, "at least one of" means any combination of items and number of items may be used from the list, but not all of the items in the list are required. The item can be a particular object, a thing, or a category.

For example, without limitation, "at least one of item A, item B, or item C" may include item A, item A and item B, or item B. This example also may include item A, item B, and item C or item B and item C. Of course, any combinations of these items can be present. In some illustrative examples, "at least one of" can be, for example, without limitation, two of item A; one of item B; and ten of item C; four of item B and seven of item C; or other suitable combinations.

The flowcharts and block diagrams in the different depicted embodiments illustrate the architecture, functionality, and operation of some possible implementations of apparatuses and methods in an illustrative embodiment. In this regard, each block in the flowcharts or block diagrams can represent at least one of a module, a segment, a function, or a portion of an operation or step. For example, one or more of the blocks can be implemented as program code, hardware, or a combination of the program code and hardware. When implemented in hardware, the hardware may, for example, take the form of integrated circuits that are manufactured or configured to perform one or more operations in the flowcharts or block diagrams. When implemented as a combination of program code and hardware, the implementation may take the form of firmware. Each block in the flowcharts or the block diagrams may be implemented using special purpose hardware systems that perform the different operations or combinations of special purpose hardware and program code run by the special purpose hardware.

In some alternative implementations of an illustrative embodiment, the function or functions noted in the blocks may occur out of the order noted in the figures. For example, in some cases, two blocks shown in succession may be performed substantially concurrently, or the blocks may sometimes be performed in the reverse order, depending upon the functionality involved. Also, other blocks may be added in addition to the illustrated blocks in a flowchart or block diagram.

The different illustrative examples describe components that perform actions or operations. In an illustrative embodiment, a component may be configured to perform the action or operation described. For example, the component may have a configuration or design for a structure that provides the component an ability to perform the action or operation that is described in the illustrative examples as being performed by the component.

Many modifications and variations will be apparent to those of ordinary skill in the art. Further, different illustrative embodiments may provide different features as compared to other illustrative embodiments. The embodiment or embodiments selected are chosen and described in order to best explain the principles of the embodiments, the practical application, and to enable others of ordinary skill in the art to understand the disclosure for various embodiments with various modifications as are suited to the particular use contemplated.

## Claims

1. A method (500) for etching a substrate using a light emitting diode (LED) lamp, comprising:
placing the substrate (506) in an etching chamber equipped with the LED lamp (508) configured to emit ultra-violet (UV) light having a selected wavelength;
submerging the substrate (512) in an electrolyte solution (510) within the etching chamber;
applying a bias voltage (512) between the substrate and the electrolyte solution;
illuminating the substrate (514) with the UV light to irradiate a surface of the substrate; and
removing the substrate (516) from the electrolyte solution once a desired etch depth is achieved.

2. The method of claim 1, wherein the selected wavelength is less than 300nm.

3. The method of claim 1 or 2, wherein the selected wavelength is 275nm.

4. The method of any preceding claim, wherein the substrate comprises silicon carbide (SiC) (114).

5. The method of any preceding claim, wherein the substrate comprises silicon oxide on insulator (SiCOI).

6. The method of any preceding claim, wherein the electrolyte solution (110) is an aqueous solution of potassium hydroxide (KOH).

7. The method of any preceding claim, wherein the electrolyte solution (110) is an aqueous solution of sodium hydroxide (NaOH) and lithium hydroxide (LiOH).

8. The method of any preceding claim, further comprising adjusting intensity of the UV light (106) to control an etching rate.

9. The method of any preceding claim, further comprising adjusting the bias voltage (120) to control an etching rate.

10. The method of any preceding claim, wherein the bias voltage is constant.

11. The method of any preceding claim, further comprising:
rinsing (518) the etched substrate with deionized water to remove any residual electrolyte solution; and
drying the substrate.

12. A system (100) for etching a substrate (114), comprising:
an etching chamber configured to hold the substrate (114);
an LED lamp (104) positioned within the etching chamber and configured to emit UV light at a wavelength of less than 300nm;
an electrolyte solution (110) comprising an aqueous solution (110) of potassium hydroxide (KOH) at a concentration ranging from 1 M to 5 M configured to submerge the substrate; and
a voltage source (120) configured to apply a bias voltage between the substrate (114) and the electrolyte solution (110), wherein a surface of the substrate is illuminated with the UV light (106) to irradiate the surface.

13. The system of claim 12, wherein the wavelength is around 275nm.

14. The system of claim 12 or 13, wherein the etching chamber, LED lamp (104), electrolyte solution (110) and voltage source (120) are operatively connected to perform a photoelectrochemical etching across the surface.

15. The system of any of claims 12 to 14, wherein the substrate (114) comprises silicon carbide (SiC), or wherein the substrate (114) comprises silicon oxide on insulator (SiCOI).
